# EUROPÄISCHE PATENTANMELDUNG

(11) **EP 0 967 846 A2**
(43) Veröffentlichungstag der Anmeldung: **29.12.1999**
(21) Anmeldenummer: 99111634.4
(22) Anmeldetag: 16.06.1999
(51) Int. Cl.: H05K 3/00, C25D 5/08

(54) **Einrichtung zur Behandlung von Gegenständen, insbesondere Leiterplatten**

(30) Priorität: 22.06.1998 DE 19827529
(71) Anmelder: Gebr. Schmid GmbH & Co., D-72250 Freudenstadt (DE)
(72) Erfinder: Schmid, Dieter C., Dipl. Ing., 72250 Freudenstadt-Dietersweiler (DE)
(74) Vertreter: Patentanwälte Ruff, Beier, Schöndorf und Mütschele

(57) **Zusammenfassung**

Durch die Erfindung wird eine Einrichtung zur Behandlung von Gegenständen geschaffen, insbesondere eine Galvanisiereinrichtung für Leiterplatten (11), wobei die Gegenstände mit Transportmitteln (19) auf einer Durchlaufbahn durch wenigstens eine Behandlungskammer (18) transportiert werden. Die Gegenstände weisen an zumindest einer Oberfläche Sacklöcher (16) auf, wobei Austreibemittel im Bereich der Durchlaufbahn zum Austreiben von für die Behandlung unerwünschten Medien aus den Sacklöchern vorgesehen sind. Derartige unerwünschte Medien können Partikel oder Gasblasen sein.

Bevorzugt werden mit Düsen (23, 28, 29, 38) Flüssigkeitsstrahlen unter hohem Druck auf die Gegenstände bzw. die Löcher gerichtet. Die Düsen können starr oder beweglich an Düsenträgern (22) befestigt sein, welche wiederum selber beweglich sein können, vorzugsweise rotierend. Alternativ ist z.B. der Einsatz von Ultraschallgeneratoren (44) als Austreibemittel möglich.

## Beschreibung

### ANWENDUNGSGEBIET UND STAND DER TECHNIK

Die Erfindung betrifft eine Einrichtung zur Behandlung von Gegenständen, insbesondere Leiterplatten, die mit Transportmitteln auf einer Durchlaufbahn durch wenigstens eine Behandlungskammer transportiert werden und an zumindest einer Oberfläche nicht durchgängige Ausnehmungen aufweisen. Eine solche Einrichtung kann eine Galvanisiereinrichtung für Leiterplatten sein.

Derartige Anlagen sind insbesondere zum Galvanisieren von Leiterplatten für elektrische Schaltungen bekannt. Die Leiterplatten bestehen aus einem Träger, beispielsweise Epoxidharz oder andere Kunststoffe, und sind an mindestens einer Oberfläche, vorzugsweise an beiden, mit einer dünnen leitfähigen Schicht, beispielsweise aus Kupfer, versehen. Eine spezielle Anwendung sind sogenannte Multi-Layer-Schaltungen, bei denen mehrere Leiterplatten direkt aufeinandergesetzt werden. Durch die aus den leitfähigen Oberflächen herausgearbeiteten Leiterbahnen kann eine hochkomplexe Verschaltung mit einer Vielzahl von Überkreuzungen von Verbindungswegen in verschiedenen Ebenen erreicht werden. Die Leiterplatten weisen beispielsweise eine Dicke von 50 µm auf, die beidseitig aufgebrachten Kupferschichten etwa 5 bis 35 µm.

Zur Durchkontaktierung von einer Kupferschicht zur anderen können Sacklöcher als nicht durchgängige Ausnehmungen durch eine Kupferschicht sowie den Träger vorgesehen sein, die anschließend an der Innenwandung mit Kupfer versehen werden, um eine Durchkontaktierung herzustellen. Die Ausnehmungen können z.B. Durchmesser im Bereich von 20 bis 120 µm aufweisen.

### AUFGABE UND LÖSUNG

Es ist Aufgabe der Erfindung, eine Einrichtung zu schaffen, die die Nachteile des Standes der Technik vermeidet, zuverlässig arbeitet sowie in einen Behandlungsprozeß integrierbar ist.

Gelöst wird diese Aufgabe durch Austreibemittel im Bereich der Durchlaufbahn zum Austreiben von für die Behandlung unerwünschten Medien, insbesondere Gasen, aus den Ausnehmungen. In diesen Ausnehmungen, die bei Multi-Layer-Leiterplatten Durchmesser im Bereich von ca. 20 µm aufweisen können, können sich Verunreinigungen festsetzen. Verunreinigungen können Materialpartikel wie Staubkörner o. dgl. sein, möglich ist auch die Bildung oder Festsetzung von Gasblasen, die sich in den mikroskopisch kleinen Ausnehmungen halten können. Derartige Gasblasen können durch die Behandlung der Leiterplatte mit Flüssigkeiten zur Vorbereitung einer Kupferbeschichtung entstehen, beispielsweise als Wasserstoffgasblase oder Luftblase. Die Austreibemittel können auf die Gegenstände direkt einwirkend ausgebildet sein, wobei eine Einwirkung vorzugsweise großflächig erfolgt. Je nach Art der Einwirkung kann sie von einer Seite oder von beiden Seiten aus erfolgen bzw. können Austreibemittel auch auf beiden Seiten angeordnet sein. Sie ist bevorzugt derart ausgebildet, daß die Oberfläche im Bereich von Sekunden immer wieder behandelt wird.

Alternativ zu einer großflächigen Einwirkung können die Austreibemittel zur Einwirkung auf einen schmalen Bereich der Gegenstände ausgebildet sein, vorzugsweise auf deren Oberfläche. Dadurch ist eine Begrenzung der Ausdehnung der Austreibemittel sowie der Einwirkungszone möglich und weitere Einrichtungen können platzsparend vorgesehen sein. Die Einwirkung kann insbesondere gerichtet und/oder gezielt erfolgen, beispielsweise um bei Ausnehmungen an immer derselben Stelle gezielt auf diese einzuwirken.

Die Austreibemittel können Beschleunigungsmittel für eine Flüssigkeit aufweisen, insbesondere zum Ausbringen von Flüssigkeit durch wenigstens eine Öffnung, beispielsweise Flüssigkeitspumpen o.dgl. Ein Spritzen oder Bestrahlen einer Flüssigkeit kann mit hohem und/oder variablem Druck erfolgen. Die Flüssigkeit ist vorzugsweise eine für einen Behandlungsprozeß notwendige oder vorteilhafte Flüssigkeit, die beispielsweise zur Behandlung der Oberfläche der Gegenstände oder zur Behandlung der Innenseite der Ausnehmungen vorgesehen ist. Auf diese Weise werden unerwünschte Verunreinigungen entfernt und eine gewünschte Benetzung mit Behandlungsflüssigkeit erzielt.

Die Öffnung für die Flüssigkeit, vorzugsweise mehrere Öffnungen, können als Düse mit einer bestimmten Richt- bzw. Strahlcharakteristik ausgebildet sein. Die Strahlcharakteristik kann durch eine verstellbare Düse vorteilhaft auf verschiedene Anwendungen abgestimmt werden. Bevorzugt weist wenigstens eine Öffnung bzw. Düse eine feste Richtung auf, wobei sie insbesondere ortsfest angeordnet ist. Feststehende Öffnungen bzw. Düsen ermöglichen einen einfachen Aufbau.

Alternativ zum festen Einbau kann eine Öffnung zum Ausbringen der Flüssigkeit beweglich sein, um die Wirkung zu erhöhen und die Anwendung flexibler zu gestalten. Die Öffnung kann mit gleichbleibender Richtung beweglich sein, bevorzugt durch Bewegung des Trägers, an dem sie angebracht ist. Alternativ und/oder zusätzlich kann sie in ihrer Richtung veränderbar sein, beispielsweise zumindest teilweise in Durchlaufrichtung der Leiterplatten. Eine Bewegung mit gleichbleibender Ausrichtung der Öffnung erfolgt bevorzugt quer oder schräg zur Durchlaufrichtung der Leiterplatten.

Die wenigstens eine Öffnung bzw. Düse ist bevorzugt an einen Düsenträger angebracht bzw. daran vorgesehen und mittels eines in dem Träger verlaufenden Kanals oder einer Leitung an die Beschleunigungsmittel angeschlossen. Eine Möglichkeit ist ein sich quer zur Durchlaufrichtung über die gesamte Breite der Gegenstände erstreckender Hohlkörper, beispielsweise ein Hohlzylinder, der Öffnungen zu den Gegenständen hin aufweist und der an wenigstens einer Stelle einen Anschluß an die Beschleunigungsmittel zur Flüssigkeitszufuhr aufweist.

Eine Bewegung der Öffnungen kann auf einfache Weise durch einen beweglichen Düsenträger erzielt werden, wobei eine Bewegung quer zur Durchlaufrichtung und/oder bevorzugt in rotierender Weise erfolgt. Bei einer Ausgestaltungsmöglichkeit der Erfindung kann der Düsenträger vollständig rotieren, insbesondere im wesentlichen kontinuierlich, vorzugsweise um eine feste Achse bzw. eine Längsachse. Alternativ kann er eine wechselnde Rotationsrichtung und einen begrenzten Rotationsbereich aufweisen, der insbesondere zwischen 10° und 150° liegt, besonders bevorzugt bei ca. 45°. Bei einer begrenzten Rotation ist es möglich, die Flüssigkeitsstrahlen stets auf die Oberfläche der Gegenstände gerichtet zu halten. Dies ermöglicht es, sowohl den Strahlwinkel zu verändern als auch vor allen die gesamte durch die Öffnungen strömende Flüssigkeit auf die Gegenstände zu richten. Eine Änderung des Strahlwinkels wird als vorteilhaft für ein Austreiben der Verunreinigungen aus den Ausnehmungen angesehen.

Mehrere Öffnungen können aufeinanderfolgend an dem Düsenträger angeordnet sein, insbesondere in Bewegungsrichtung der Gegenstände. Vorteilhaft bilden die Öffnungen quer bzw. schräg zur Durchlaufrichtung einen durchgängigen auf die Oberfläche der Gegenstände gerichteten Bereich. Vorzugsweise können sie jeweils versetzt zueinander angeordnet sein, um einen durchgängigen Bereich zu bilden. Mehrere aufeinanderfolgend an dem Düsenträger angeordnete Öffnungen können in verschiedene Richtungen weisen, um verschiedene Einstrahlwinkel zur Oberfläche der Gegenstände zu ermöglichen. Auf diese Weise können jeweils Abschnitte bzw. Streifen auf der Oberfläche in verschiedenen Einstrahlwinkeln mit Flüssigkeit behandelt bzw. bearbeitet werden.

Wenigstens eine Öffnung kann als Schlitz ausgeführt sein. Sie kann quer oder schräg zu der Durchlaufrichtung verlaufen, wobei ein Schlitz eine begrenzte Länge aufweisen kann. Eine besonders einfache Anwendung kann einen über die gesamte Breite der Durchlaufbahn reichenden Schlitz vorsehen. Vorteilhaft sind mehrere Schlitze an einem Düsenträger schräg zur Durchlaufrichtung verlaufend vorgesehen. Ein spitzer Winkel, insbesondere im Bereich von ca. 60°, wird als vorteilhaft angesehen, und wenigstens zwei Schlitze können sich in Durchlaufrichtung jeweils überlappen, um eine vollständige Bedeckung der Durchlaufbahn während des Durchlaufens sicherzustellen.

Der Düsenträger kann einen rotierenden Düsenkopf aufweisen bzw. als rotierender Düsenkopf ausgebildet sein, wobei der Düsenkopf vorteilhaft mehrere Düsen als Öffnungen aufweist. Die Rotationsachse verläuft bevorzugt durch die Ebene der Gegenstände, besonders bevorzugt ist sie in ihrer Ausrichtung veränderbar. Zusätzlich zu einer Rotation ist beispielsweise eine Präzession nach Art eines taumelnden Kreisels möglich.

Eine Alternative zu einen kontinuierlichen Flüssigkeitsausstoß ist durch das Vorsehen von Unterbrechungsmitteln für einen Flüssigkeitsstrom möglich. Bevorzugt sind die Unterbrechungsmittel im Bereich der Öffnungen bzw. Düsen angebracht, insbesondere durch den Flüssigkeitsstrom selber betätigbar. Eine Unterbrechung kann auch dergestalt möglich sein, daß durch eine bestimmte Anordnung von Abstufungen o. dgl. die Flüssigkeit in einer Art Resonanzbildung pulsweise austritt. Ein stoßartiges bzw. pulsartiges Ausbringen von Flüssigkeit kann zusätzlich zu dem reinen Flüssigkeitsstrom eine Art Minierschütterung der Gegenstände bewirken, wodurch das Eindringen der Flüssigkeit in die Ausnehmungen und ein Austreiben von Verunreinigungen verbessert werden kann. Als Alternative zu Unterbrechungsmitteln im Bereich der Öffnungen ist ein stoßartiges Pumpen der Flüssigkeit eine einfache und wirkungsvolle Möglichkeit.

Als Alternative zum Behandeln der Oberfläche mit einem Flüssigkeitsstrom können die Austreibemittel wenigstens eine Ansaugöffnung zum Ansaugen von Flüssigkeit aufweisen. Wenn diese möglichst nahe an den Gegenständen angeordnet ist, können Verunreinigungen auf diese Weise entfernt werden. Die Beschleunigungsmittel sind beispielsweise als Saugpumpen ausgebildet.

Ebenso ist es beispielsweise möglich, anstelle einer Einwirkung durch Flüssigkeit einen Ultraschallgenerator vorzusehen. Er kann auf wenigstens einer Seite der Durchlaufbahn mit Abstrahlrichtung zu den Gegenständen angeordnet sein und diese durch Ultraschallwellen erschüttern, um die Verunreinigungen aus den Ausnehmungen zu lösen. Bei einer Behandlung der Gegenstände in einem Flüssigkeitsbad kann durch Ultraschallwellen die Flüssigkeit selber gegen die Gegenstände bzw. die Ausnehmungen bewegt werden.

Eine weitere Möglichkeit kann vorsehen, die Gegenstände direkt mechanisch zu erschüttern bzw. zum Vibrieren zu bringen. Möglich ist dies beispielsweise durch eine Vibrationseinrichtung, die entweder direkt oder aber über die Transportmittel auf die Gegenstände einwirken kann.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

In den Zeichnungen sind einige bevorzugte Ausführungsbeispiele der Erfindung dargestellt und werden im folgenden beschrieben. In den Zeichnungen zeigen:
- Fig. 1: einen Querschnitt durch eine Leiterplatte mit beidseitiger Kupferbeschichtung, die Durchbrüche und Sacklöcher aufweist,
- Fig. 2: eine Behandlungskammer mit Durchlaufbahn für eine Leiterplatte, die von einer unten liegenden Düse eines Düsenträgers mit Flüssigkeit angestrahlt werden kann,
- Fig. 3: eine Draufsicht auf den Düsenträger samt Düse aus Fig. 2, wobei die Düsenöffnung ein langer Schlitz ist,
- Fig. 4: eine alternative Ausführung einer Düse aus Fig. 3 mit hintereinander angeordneten Düsenlöchern, wobei die gesamte Düsenanordnung in Längsrichtung hin- und her bewegbar ist,
- Fig. 5: eine Düsenanordnung ähnlich Fig. 4, bei der anstelle von Rundlöchern parallele schräge Schlitze die Düsenöffnungen bilden,
- Fig. 6: eine Anordnung ähnlich Fig. 2 samt Düsenträger, der um seine Längsachse rotiert,
- Fig. 7: eine Draufsicht auf den Düsenträger aus Fig. 6, der in schrägen Linien hintereinander angeordnete Düsenöffnungen aufweist,
- Fig. 8: eine Anordnung ähnlich Fig. 2 mit einem schwenkbar gelagerten Düsenträger, der zur verbesserten Richtcharakteristik Längsdüsen aufweist,
- Fig. 9: eine Darstellung des Düsenträgers aus Fig. 8 mit aufrecht gestellter Längsdüse,
- Fig. 10: eine Anordnung ähnlich Fig. 2, mit einem unterhalb der Leiterplatte angeordneten Düsenträger, der rotierende Unterbrecher für die Flüssigkeitsstrahlen aufweist,
- Fig. 11: eine Draufsicht auf den Düsenträger von Fig. 11, bei dem die Abdeckung entfernt wurde um die rotierenden Unterbrecher zu zeigen und
- Fig. 12: eine Anordnung ähnlich Fig. 2, bei der unterhalb der Leiterplatte ein Ultraschallgenerator angeordnet ist.

### DETAILLIERTE BESCHREIBUNG DER AUSFÜHRUNGSBEISPIELE

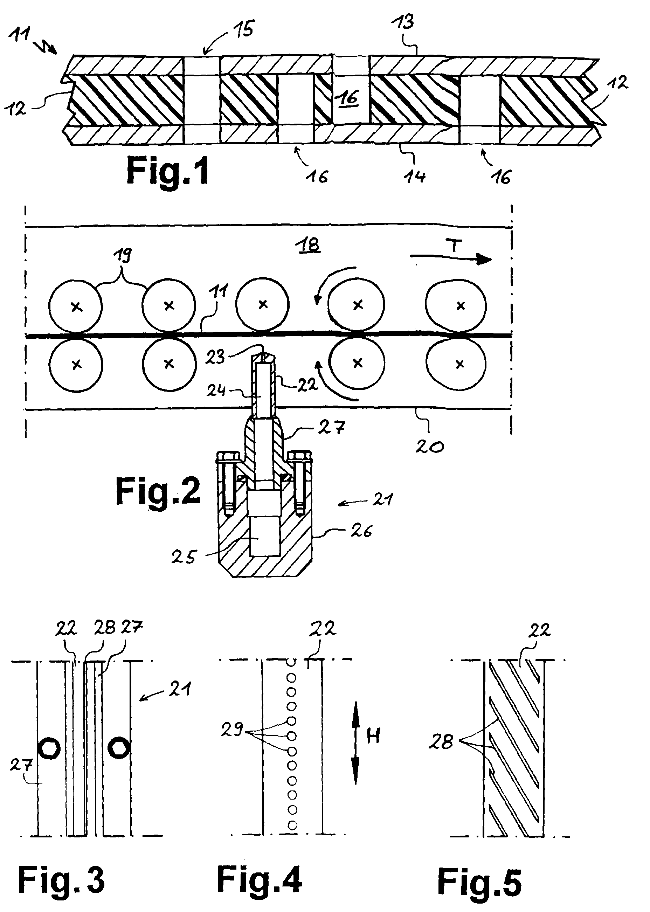

Die Fig. 1 zeigt im Querschnitt den Aufbau einer Leiterplatte 11 aus Trägerschicht 12 und oberer Kupferschicht 13 sowie unterer Kupferschicht 14. Die Leiterplatte 11 weist durchgängige Durchbrüche 15 sowie Sacklöcher 16 auf, welche durch jeweils eine der beiden Kupferschichten 13 oder 14 und die Trägerschicht 12 verlaufen. Die Abmessungen derartiger Leiterplatten 11 sind sehr gering. So kann die Dicke der Trägerschicht 12 beispielsweise 50 µm betragen, die der Kupferschichten 13, und 14 jeweils etwa 20 µm. Der Bohrungsdurchmesser der Durchbrüche bzw. Sacklöcher kann zwischen 20 und 120 µm variieren, wobei vorzugsweise alle Bohrungen einer Leiterplatte 11 gleichen Durchmesser aufweisen, in der Fig. 1 etwa 40 µm.

Die Fig. 2 zeigt einen Teil einer Behandlungseinrichtung für Leiterplatten, in dem die in Fig. 1 gezeigten Durchbrüche 15 und Sacklöcher 16 der Leiterplatte 11 von Verunreinigungen, insbesondere Gas- bzw. Wasserstoffgasblasen gereinigt werden sollen und gleichzeitig mit einer Behandlungsflüssigkeit behandelt werden. Die Einrichtung kann eine Galvanisierungseinrichtung sein, möglich ist aber eine Vielzahl von Anwendungen, beispielsweise Aktivieren, Konditionieren, Spülen u.s.w. Besonders bevorzugt wird die Erfindung im Bereich der Leiterplattenherstellung eingesetzt.

Die Leiterplatten 11 können entsprechend Fig. 1 wenigstens eine Kupferschicht tragen und z.B. nur in den Sacklöchern oder Durchbrüchen beschichtet werden. Alternativ bestehen sie nur aus dem Träger und werden in der Behandlungskammer 18 beispielsweise zur Kupferbeschichtung vorbereitet.

In der Behandlungskammer 18 kann ein Flüssigkeitsbad zur Behandlung vorgesehen sein, beispielsweise mit einer stehenden Welle oder einer Spülung, beispielsweise im Schwallverfahren. Die Darstellung der Behandlungseinrichtung ist durch das bewußte Auslassen von Details einfach gehalten und beschränkt sich auf die Behandlungskammer 18, in der Transportrollen 19 die Leiterplatte 11 von links nach rechts in Durchlaufrichtung T befördern. Sowohl links als auch rechts schließen sich weitere Abschnitte der Einrichtung an die Behandlungskammer 18 an. Links kann dies beispielsweise ein chemisches Bad zur Benetzung der Oberfläche der Leiterplatte 11 mit Vorbereitungschemikalien für die Beschichtung mit Kupfer sein, rechts beispielsweise die Kupferbeschichtung selber.

Unterhalb der Leiterplatte 11 ist anstelle einer Transportrolle 19 eine im Querschnitt dargestellte Bestrahlungseinrichtung 21 in dem Boden 20 der Kammer angeordnet, die einen auf die Unterseite 14 der Leiterplatte 11 gerichteten Düsenträger 22 trägt. Dessen Spitze weist eine Düse 23 auf, die über einen Kanal 24 an eine Flüssigkeitsleitung 25 in der Bestrahlungseinrichtung 21 verbunden ist.

Die Bestrahlungseinrichtung 21 besteht aus einem Grundteil 26, das zumindest abschnittsweise nach oben geöffnet ist. Mittels Dichtungen abgedichtet werden Aufsätze 27 daraufgesetzt und verschraubt. Die Aufsätze 27 wiederum tragen den wenigstens einen Düsenträger 22. Auf diese Weise kann eine vielseitige und variable Bestrahlungseinrichtung zum Entfernen von störenden Verunreinigungen aus Durchbrüchen und Sacklöchern flachen Gegenständen geschaffen werden. So ist es möglich, durch Wechseln der Düsenträger 22 bzw. der Aufsätze 27 die Anordnung schnell und einfach umzubauen, um sie verschiedenen Gebrauchszwecken anzupassen. Der Grundteil 26 kann starr und ortsfest angeordnet sein, alternativ kann er über nicht dargestellte Antriebe bewegbar sein, insbesondere in seiner Längsrichtung. Er erstreckt sich bevorzugt über die gesamte Breite der Durchlaufbahn.

Es ist möglich, die Aufsätze 27 bzw. den Düsenträger 22 bewegbar auszuführen. Die Antriebe hierfür können an dem Grundteil 26 oder dem bewegbaren Teil vorgesehen sein.

Der Grundteil 26 weist in seiner Längsrichtung verlaufend die Flüssigkeitsleitung 25 auf, die stellenweise oder vollständig nach oben geöffnet ist als Zuführung zu dem Kanal 24 des Düsenträgers 22 bzw. dem Aufsatz 27. Nicht dargestellt ist ein externer Anschluß oder eine Pumpvorrichtung zum Erzeugen des Flüssigkeitsstromes oder eines anderen Stromes.

Eine weitere Betriebsart der in Fig. 2 gezeigten Anordnung kann eine Saugvorrichtung durch Unterdruck sein. Dabei wird durch die Düsen 23 nicht Flüssigkeit gegen die Leiterplatte 11 gerichtet, sondern durch starken Unterdruck in den Kanal 24 eingesogen. Der strukturelle Aufbau kann ähnlich wie bei der Bestrahlungseinrichtung 21 gehalten sein. Als Unterschied wird Flüssigkeit angesaugt anstatt ausgestoßen. Des weiteren ist es bei einer Ansaugvorrichtung vorteilhaft, die Ansaugöffnung bzw. Düse möglichst nahe an der Leiterplatte zu positionieren, um ein Absaugen von Verunreinigungen bzw. Gasblasen aus Ausnehmungen in der Leiterplatte sicherzustellen.

Die Fig. 3 zeigt die Blaseinrichtung 21 aus Fig. 2 von oben. Dabei ist als eine Ausführungsmöglichkeit von Aufsatz 27 und Düsenträger 22 eine langgestreckte Version dargestellt. Die Düse 23 ist als in Längsrichtung verlaufender Schlitz ausgeführt. Auf diese Weise ist eine lückenlose Bedeckung der Oberfläche der Leiterplatte 11 mit Flüssigkeit bei Anordnung der Bestrahlungseinrichtung 21 quer oder schräg zur Durchlaufrichtung T der Leiterplatte möglich.

Die Fig. 4 zeigt in vergrößerter Darstellung eine Draufsicht auf einen Düsenträger 22, der in Längsrichtung hintereinander angeordnet kleine Düsenlöcher 29 aufweist. Sie sind mittig in dem Düsenträger 22 angebracht, wobei ihr Abstand in etwa ihrem Durchmesser entspricht.

Da bei einer Anordnung des Düsenträgers 22 quer zur Durchlaufrichtung T streifenförmige Abschnitte der Leiterplatte 11 zwischen den Düsenlöchern 29 einem Flüssigkeitsstrahl nicht direkt ausgesetzt wären, wird der Düsenträger 22 vorteilhaft in seiner Längsrichtung durch eine lineare Hin- und Herbewegung H bewegt, um auf diese Weise im wesentlichen die gesamte Breite der Leiterplatte zu überstreichen.

Die Fig. 5 zeigt einen Düsenträger 22, der ebenso den Düsenträger aus Fig. 3 ersetzen kann. Anstelle eines durchgängigen Düsenschlitzes 28 oder hintereinander in Längsrichtung angeordneter Düsenlöcher 29 ist eine Vielzahl von schräg zur Längsrichtung des Düsenträgers 22 verlaufenden Düsenschlitzen 28 vorgesehen. Sie verlaufen in einem Winkel von etwa 30° zur Längsachse des Düsenträgers und bedecken etwa 80% der Breite desselben. Die Düsenschlitze 28 sind sämtlich parallel zueinander, wobei der Beginn eines Schlitzes in Querrichtung zu dem Düsenträger das Ende des jeweils übernächsten Schlitzes überlappt. Auf diese Weise kann bei einen starr angeordneten Düsenträger 22 mindestens eine doppelte Bestrahlung der Oberfläche der Leiterplatte 11 mit Flüssigkeitsstrahlen erfolgen.

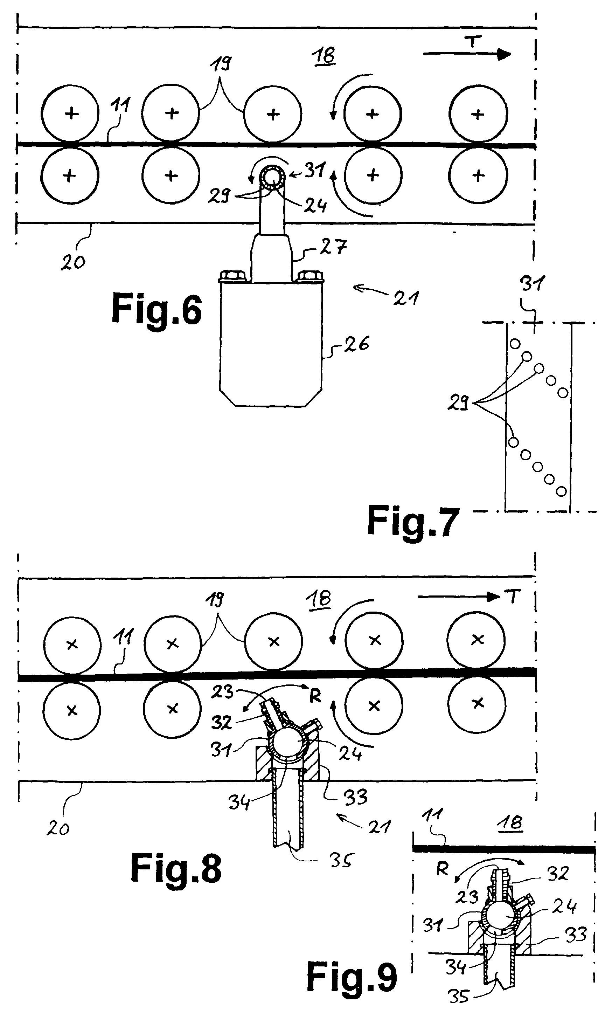

Die Fig. 6 zeigt eine Behandlungskammer 18 entsprechend der aus Fig. 2 mit Transportrollen 19, die eine Leiterplatte 11 in Durchlaufrichtung T bewegen. Das Grundteil 26 trägt einen Aufsatz 27 mit einem rotierenden Düsenträger 31. Der Düsenträger 31 ist jeweils zwischen zwei beabstandeten Aufsätzen 27 drehbar gelagert. Dabei ist der Abstand der Aufsätze 27 vorzugsweise größer als die Breite der Leiterplatte 11, so daß sich der Düsenträger 31 über die gesamte Leiterplattenbreite erstreckt.

Der Düsenträger 31 ist nach Art eines Hohlzylinders oder Rohres ausgebildet, mit einem zentralen Kanal 24 zur Flüssigkeitszufuhr zu den durch den Düsenträger 31 reichenden Düsenlöchern 29. Eine Zuführung von Flüssigkeit in den Kanal 24 erfolgt vorzugsweise über zumindest einen der Aufsätze 27 an der Lagerung des Düsenträgers 31. Es ist ein Rotationsantrieb für den Düsenträger vorgesehen, bevorzugt als Elektromotor. Alternativ kann eine Rotationsbewegung des Düsenträgers allgemein durch eine spezielle Ausrichtung der Düsenlöcher 29 als Rückstoßdüsen erzielt werden, wobei die unter Druck austretende Flüssigkeit den Düsenträger rotieren läßt. Die Rotationsrichtung des Düsenträgers weist vorteilhaft, wie in Fig. 6 dargestellt, entgegen der Durchlaufrichtung T der Leiterplatte 11.

Die Fig. 7 zeigt eine Draufsicht auf den Düsenträger 31 aus Fig. 6. Man erkennt die spiralförmig entlang des Trägers angebrachten Düsenlöcher 29, die entlang einer Spirallinie angebracht sind, welche in einem Winkel von etwa 45° zur Längsachse des Trägers verläuft. Der Abstand der Düsenlöcher liegt etwas über ihrem Durchmesser, so daß sich in der Bewegungsrichtung T der Leiterplatte die von den einzelnen Düsenlöchern 29 angestrahlten Bereiche gegenseitig überdecken. Um jederzeit eine Überdeckung der gesamten Leiterplattenbreite zu erreichen, können zwei oder mehr parallel verlaufende Spirallinien von Düsenlöchern an dem Düsenträger vorgesehen werden.

Eine Anordnung mit einem rotierenden Düsenträger 32, dessen Flüssigkeitsstrahlen allerdings jederzeit auf die Leiterplatte 11 gerichtet sind, zeigt Fig. 8. Behandlungskammer 18, Transportrollen 19 und Leiterplatte 11 entsprechen Fig. 2. Der rotierende Düsenträger 31 weist einen abstehenden Düsenansatz 32 auf, der eine Düse 23 aufweist. Er ist drehbar in einer Halterung 33 gelagert, die an dem Boden 20 der Behandlungskammer 18 angebracht ist. Ein in Längsrichtung verlaufender zentraler Kanal 24 ist über eine Verbindungsöffnung 34 mit einer Flüssigkeitszuführung 35 verbunden. Alternativ zu der dargestellten Flüssigkeitszuführung über die Verbindungsöffnung 34 ist eine Einleitung an einem Ende des vorzugsweise länglichen Düsenträgers 31 entsprechend Fig. 6 möglich. In dem Bereich, in dem der Düsenträger 31 in der Halterung 33 gelagert ist, sind die beiden Teile mit einer Gleitdichtung gegeneinander abgedichtet. Der Rotationswinkel R ist so gewählt, daß die Verbindungsöffnung 34 jeweils vollständig zu der Flüssigkeitszuführung 35 hin frei ist. Der Rotationswinkel R liegt in dem in Fig. 8 dargestellten Beispiel bei etwa 45°.

Die Düsen 23 können beispielsweise entsprechend einer der in den Figuren 3 bis 5 dargestellten Möglichkeiten gestaltet sein. Bei einer Ausführung entsprechend Fig. 4 mit einer Vielzahl von Düsenlöchern 29 können jeweils einzelne Düsenansätze 32 vorgesehen sein.

Fig. 9 zeigt den im Vergleich zu Fig. 8 nach rechts verschwenkten Düsenträger 31, dessen Düsenansatz 32 samt Düse 23 in etwa senkrecht auf die Leiterplatte 11 zu weist. Man sieht, daß in dieser Stellung die Verbindungsöffnung 34 mit ihrem Rand gerade an der seitlichen Abdichtung zu der Halterung 33 angekommen ist. Eine weitere Verdrehung des Düsenträgers 31 im Uhrzeigersinn würde eine zumindest partielle Abdeckung der Verbindungsöffnung 34 und somit eine Reduktion der Flüssigkeitseinströmung in den Kanal 24 zur Folge haben, was im allgemeinen vermieden werden sollte. Eine Flüssigkeitszuführung an den Enden des Düsenträgers 31 entsprechend Fig. 6 kann hier Abhilfe schaffen.

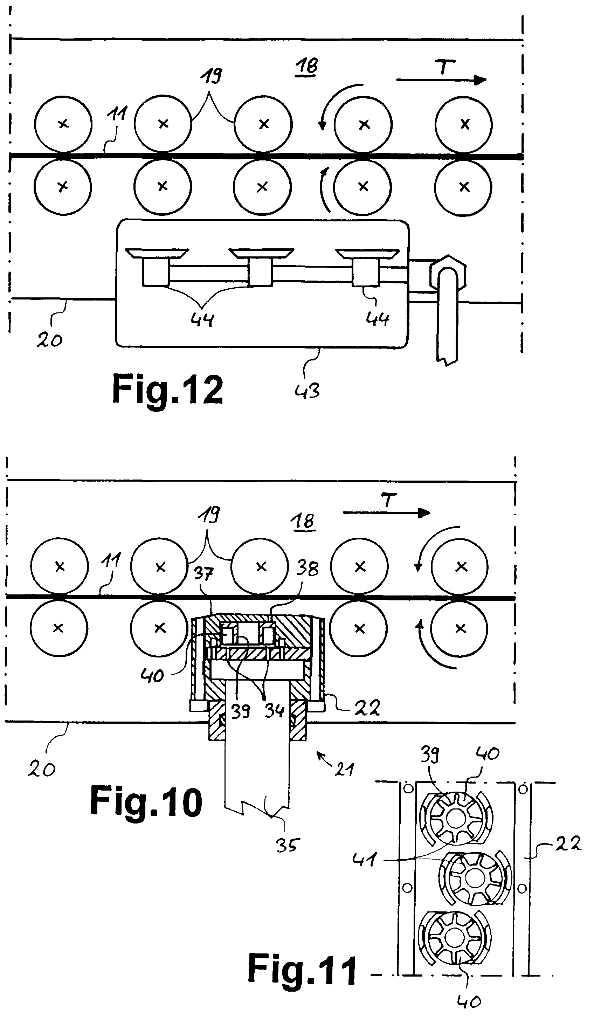

Die Fig. 10 zeigt eine Behandlungskammer 18 samt Transportrollen 19 und einer Leiterplatte 11 entsprechend Fig. 2. Hier sind die Austreibemittel zur pulsierenden Bestrahlung der Leiterplattenoberfläche mit Flüssigkeitsstrahlen ausgebildet. Dazu weist ein Düsenträger 22, der eine Abdeckung 37 mit einer Ausgangsöffnung 38 aufweist auf die Leiterplatte. Unter der Ausgangsöffnung 38 sind rotierende Unterbrecher 39 angebracht, deren Aufbau in Fig. 11 verdeutlicht wird. Über zwei Verbindungsöffnungen 34 strömt Flüssigkeit aus einer Flüssigkeitszuführung 35 zu den Unterbrechern 39, die die Verbindung zu der Ausgangsöffnung 38 kurzzeitig abdecken und anschließend wieder freigeben. Diese Abdeckung und Freigabe erfolgt, wie in Fig. 10 dargestellt, bevorzugt auf rotierende Weise. Möglich ist auch eine pulsierende Unterbrechung.

Der Düsenträger 22 erstreckt sich vorzugsweise über die gesamte Leiterplattenbreite. Entlang seiner Ausdehnung sind Ausgangsöffnungen 38 mit Unterbrechern 39 angeordnet, um die Leiterplattenoberfläche vollständig mit Flüssigkeitsstrahlen abzudecken.

Die Fig. 11 zeigt eine Draufsicht auf den Düsenträger 22 aus Fig. 10 mit abgenommener Düsenabdeckung 37. Deutlich zu erkennen sind die Unterbrecher 39, die nach Art von sternförmigen Rädern bzw. Speichenrädern gebildet sind. Durch Rotation überdecken die Speichen 41 jeweils kurzzeitig die über den Verteilerkammern 40 angebrachten Ausgangsöffnungen 38 und geben sie anschließend wieder frei. Je nach Verhältnis der Breite der Speichen 41 zu den zwischen den Speichen liegenden Freiräumen kann die Pulsfrequenz in Abhängigkeit von der Drehfrequenz variiert werden. Vorzugsweise sind konzentrisch zu dem Unterbrecher 39 mehrere Ausgangsöffnungen 38 ringförmig über der gesamten Verteilerkammer 40 angeordnet, beispielsweise doppelt so viele wie Speichen 41. Auf diese Weise wird permanent Flüssigkeit auf die Leiterplatte 11 gelenkt.

Die Unterbrecher 39 können extern angetrieben werden. Alternativ ist eine Ausführung der Speichen nach Art von Propellern oder Turbinenschaufeln möglich, durch die die Unterbrecher infolge der an den Speichen durch die Ausgangsöffnungen 38 vorbei strömenden Flüssigkeit in rotatorischer Weise angetrieben werden.

Düsen bzw. Austreibemittel sind bevorzugt an den Seiten der Leiterplatten vorgesehen, an denen diese Ausnehmungen aufweisen oder mit Flüssigkeit behandelt werden sollen.

Die Fig. 12 zeigt eine Alternative zu Flüssigkeitsstrahleinrichtungen. Eine Behandlungskammer 18 weist in bekannter Weise Transportrollen 19 sowie eine Leiterplatte 11 auf. An einer Seite der Leiterplatte 11, in Fig. 12 auf der Unterseite, ist ein Ultraschallgerät 43 mit drei in Durchlaufrichtung T hintereinander angeordneten Ultraschallgeneratoren 44 angeordnet. Die Ultraschallgeneratoren 44 sind auf die Leiterplatte 11 gerichtet. Bevorzugt sind derartige Ultraschallgeneratoren über die gesamte Breite der Leiterplatte 11 vorgesehen. Die Ultraschallgeneratoren können permanent oder im Intervallbetrieb arbeiten. Dabei ist es durch eine flächenmäßige Anordnung von Generatoren möglich, bestimmte Einwirkungen der Ultraschallwellen auf die Leiterplatte bzw. ein bestimmtes Verhalten derselben zu erzielen. So kann sie einerseits in einem bestimmten großflächigen Bereich in permanente harmonische Schwingungen versetzt werden. Alternativ sind Schwingungen möglich mit wechselnden Beschleunigungen, durch die in den Ausnehmungen der Leiterplatte befindliche Verunreinigungen und/oder Gasblasen unter Umständen besser gelöst und entfernt werden können.

Es sind Kombinationen verschiedener beschriebener Austreibemittel möglich, beispielsweise Ultraschallgeneratoren und eine Bestrahlung mit Flüssigkeit.

## Patentansprüche

1. Einrichtung zur Behandlung von Gegenständen, insbesondere Leiterplatten (11), die mit Transportmitteln auf einer Durchlaufbahn durch wenigstens eine Behandlungskammer (18) transportiert werden und an zumindest einer Oberfläche nichtdurchgängige Ausnehmungen (16) aufweisen, gekennzeichnet durch Austreibemittel (21, 43) im Bereich der Durchlaufbahn zum Austreiben von für die Behandlung unerwünschten Medien, insbesondere Gasen, aus den Ausnehmungen.

2. Einrichtung nach Anspruch 1, dadurch gekennzeichnet, daß die Austreibemittel (21, 43) zur Einwirkung auf die Gegenstände (11) ausgebildet sind, vorzugsweise großflächig, insbesondere von einer Seite aus.

3. Einrichtung nach Anspruch 1, dadurch gekennzeichnet, daß die Austreibemittel (21, 43) zur Einwirkung auf einen schmalen Bereich der Gegenstände (11) ausgebildet sind, vorzugsweise zur Einwirkung auf die Oberfläche der Gegenstände, wobei die Einwirkung insbesondere gerichtet und/oder gezielt ist.

4. Einrichtung nach einem der vorhergehenden Ansprüche, dadurch gekennzeichnet, daß die Austreibemittel (21, 43) Beschleunigungsmittel für eine Flüssigkeit aufweisen, insbesondere zum Ausbringen von Flüssigkeit durch wenigstens eine Öffnung (23, 28, 29, 38), die vorzugsweise eine Düse ist, wobei die Flüssigkeit insbesondere eine Behandlungsflüssigkeit ist.

5. Einrichtung nach Anspruch 4, dadurch gekennzeichnet, daß wenigstens eine Öffnung (23, 28, 29, 38) zum Ausbringen der Flüssigkeit beweglich ist, wobei sie insbesondere in ihrer Richtung veränderbar ist, vorzugsweise zumindest teilweise in Durchlaufrichtung (T) der Gegenstände (11) veränderbar.

6. Einrichtung nach Anspruch 4 oder 5, dadurch gekennzeichnet, daß die wenigstens eine Öffnung (23, 28, 29, 38) an mindestens einem Düsenträger (22) angebracht ist und mittels eines darin verlaufenden Kanals (24) an die Beschleunigungsmittel angeschlossen ist.

7. Einrichtung nach Anspruch 6, dadurch gekennzeichnet, daß der Düsenträger (22) beweglich ist, insbesondere in rotierender Weise, wobei er vorzugsweise eine wechselnde Rotationsrichtung und einen begrenzten Rotationsbereich (R) aufweist, der insbesondere zwischen 10° und 150° liegt.

8. Einrichtung nach einem der Ansprüche 4 bis 7, dadurch gekennzeichnet, daß mehrere Öffnungen (23, 28, 29) aufeinanderfolgend an dem Düsenträger (22) angeordnet sind, insbesondere in Durchlaufrichtung (T), vorzugsweise jeweils versetzt zueinander, wobei sie insbesondere in verschiedene Richtungen weisen.

9. Einrichtung nach einem der Ansprüche 4 bis 8, dadurch gekennzeichnet, daß wenigstens eine Öffnung als Schlitz (28) ausgeführt ist, der insbesondere quer oder schräg zu der Durchlaufrichtung (T) verläuft.

10. Einrichtung nach Anspruch 9, gekennzeichnet durch mehrere Schlitze (28) an einem Düsenträger (22), die schräg zur Durchlaufrichtung (T) verlaufen, insbesondere in einem Winkel von ca. 60°, wobei sich in Durchlaufrichtung wenigstens zwei Schlitze überlappen.

11. Einrichtung nach Anspruch 6, dadurch gekennzeichnet, daß der Düsenträger (22) als Rohr (31) ausgebildet ist, wobei er vorzugsweise quer zur Durchlaufrichtung (T) verläuft, insbesondere an seinen Enden außerhalb des Bereichs des Gegenstandes (11) gelagert ist.

12. Einrichtung nach Anspruch 6, dadurch gekennzeichnet, daß der Düsenträger (22) einen rotierenden Düsenkopf aufweist, insbesondere mit mehreren Düsen (23, 29, 38), dessen Rotationsachse vorzugsweise durch die Ebene der Gegenstände (11) verläuft, wobei sie insbesondere veränderbar ist.

13. Einrichtung nach einem der Ansprüche 4 bis 12, dadurch gekennzeichnet, daß den Öffnungen (23, 28, 29, 38) Unterbrechungsmittel (39) zugeordnet sind, die vorzugsweise durch den Flüssigkeitsstrom betätigbar sind, wobei ein ausgebrachter Flüssigkeitsstrom insbesondere gepulst ist.

14. Einrichtung nach Anspruch 4, dadurch gekennzeichnet, daß die Austreibemittel (21, 43) wenigstens eine Ansaugöffnung zum Ansaugen von Flüssigkeit aufweisen, die vorzugsweise möglichst nahe an den Gegenständen (22) angeordnet ist, wobei die Beschleunigungsmittel als Saugpumpen ausgebildet sind.

15. Einrichtung nach Anspruch 1 oder 2, dadurch gekennzeichnet, daß die Austreibemittel einen Ultraschallgenerator (44) aufweisen, der auf wenigstens einer Seite der Gegenstände (11) mit Abstrahleinrichtung auf diese angeordnet ist.
